# EUROPEAN PATENT APPLICATION

(11) **EP 4 050 726 A1**
(43) Date of publication of application: **31.08.2022**
(21) Application number: 22150673.6
(22) Date of filing: 10.01.2022
(51) Int. Cl.: H01P 3/08

(54) **INTEGRATED CIRCUIT SUPPORTS WITH MICROSTRIPS**

(30) Priority: 24.02.2021 US 202117183572
(71) Applicant: Intel Corporation, Santa Clara, CA 95054 (US)
(72) Inventor: Sutono, Albert, Chandler, 85226 (US); Ye, Xiaoning, Portland, 97229 (US)
(74) Representative: Goddar, Heinz J.

(57) **Abstract**

Disclosed herein are integrated circuit (IC) supports with microstrips, and related embodiments. For example, an IC support may include a first microstrip; a first surface dielectric region over the first microstrip, wherein the first surface dielectric region has a first thickness, and the first thickness is nonzero; a second microstrip; and a second surface dielectric region over the second microstrip, wherein the second surface dielectric region has a second thickness, the second thickness is nonzero, and the first thickness is different than the second thickness.

## Description

### Background

High-speed interconnects in circuit boards may take any of a number of forms. For example, microstrip architectures include a conductive trace spaced apart from a ground plane by a dielectric material, while stripline architectures sandwich a conductive trace between dielectric materials and ground planes.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a side, cross-sectional view of an example integrated circuit (IC) support structure, in accordance with various embodiments.
FIG. 2 is a top view of an example IC assembly including an IC support structure, in accordance with various embodiments.
FIG. 3 is a flow diagram of an example method of manufacturing an IC support structure, in accordance with various embodiments.
FIG. 4 is a side, cross-sectional view of another example IC support structure, in accordance with various embodiments.
FIG. 5 is a top view of another example IC assembly including an IC support structure, in accordance with various embodiments.
FIG. 6 is a top view of a wafer and dies that may be included in an IC support structure in accordance with any of the embodiments disclosed herein.
FIG. 7 is a side, cross-sectional view of an IC device that may be included in an IC support structure in accordance with any of the embodiments disclosed herein.
FIG. 8 is a side, cross-sectional view of an IC package that may include an IC support structure in accordance with any of the embodiments disclosed herein.
FIG. 9 is a side, cross-sectional view of an IC device assembly that may include an IC support structure in accordance with any of the embodiments disclosed herein.
FIG. 10 is a block diagram of an example electrical device that may include an IC support structure in accordance with any of the embodiments disclosed herein.

### Detailed Description

Disclosed herein are integrated circuit (IC) supports with microstrips, and related embodiments. For example, an IC support may include a first microstrip; a first surface dielectric region over the first microstrip, wherein the first surface dielectric region has a first thickness, and the first thickness is nonzero; a second microstrip; and a second surface dielectric region over the second microstrip, wherein the second surface dielectric region has a second thickness, the second thickness is nonzero, and the first thickness is different than the second thickness.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the subject matter disclosed herein. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrases "A and/or B" and "A or B" mean (A), (B), or (A and B). For the purposes of the present disclosure, the phrases "A, B, and/or C" and "A, B, or C" mean (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, a "package" and an "IC package" are synonymous. When used to describe a range of dimensions, the phrase "between X and Y" represents a range that includes X and Y. As used herein, the term "conductivity" refers to electrical conductivity unless otherwise specified. As used herein, an "IC support structure" refers to a structure that is included in a component that, directly or indirectly, supports an IC device or another electronic device; examples of IC supports that may include any of the IC support structures disclosed herein may include package substrates, interposers, and circuit boards (e.g., motherboards).

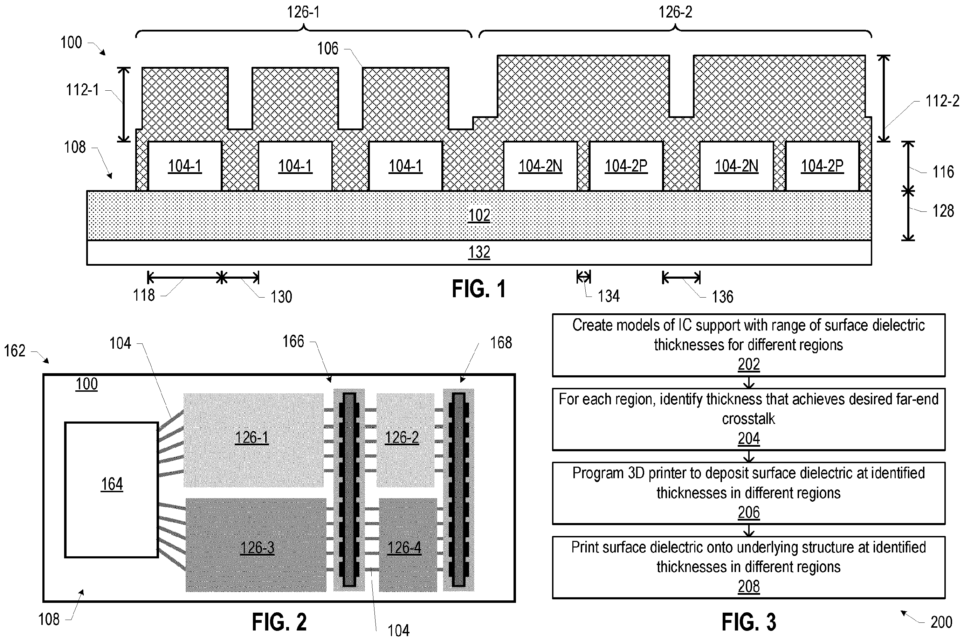

FIG. 1 is a side, cross-sectional view of a portion of an example IC support structure 100, in accordance with various embodiments. The IC support structure 100 of FIG. 1 may include multiple microstrips, with each microstrip including a conductive line 104 spaced apart from a ground plane 132 by a dielectric material 102. The microstrips of FIG. 1 include a number of single-ended microstrips (having conductive lines 104-1) and a number of differential microstrips (having conductive lines 104-2 arranged in pairs of a conductive line 104-2N and a conductive line 104-2P carrying electrical signals with opposite polarity, as shown); an IC support structure 100 may include one or more single-ended microstrips and/or one or more differential microstrips, arranged as desired. Although particular ones of conductive lines 104-2 are labeled as negative "N" and positive "P," the particular arrangement depicted in FIG. 1 is simply illustrative, and any desired arrangement of negative and positive conductive lines 104-2 in a differential pair may be used. Although the conductive lines 104 are shown as having a rectangular cross-section, this is simply for ease of illustration, and a conductive line 104 may have any suitable cross-sectional shape (e.g., a trapezoidal and/or a rounded shape).

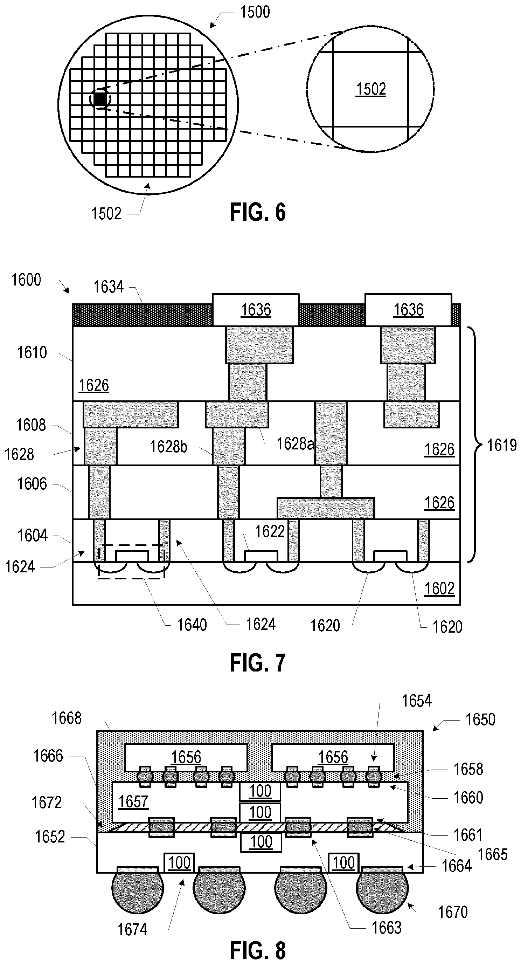

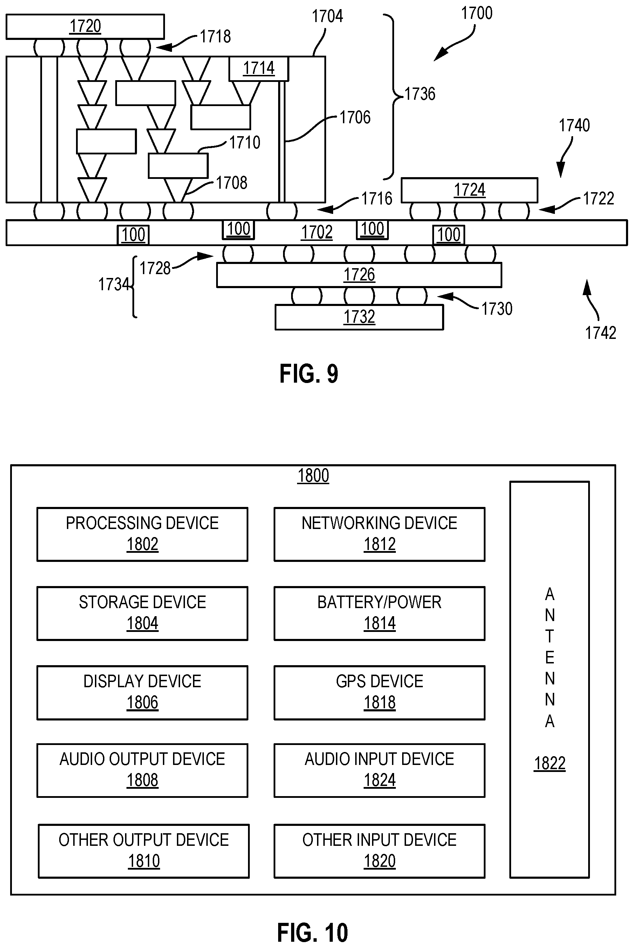

As shown, a single monolithic ground plane 132 may provide the ground plane 132 for multiple microstrips; similarly, a single monolithic portion of dielectric material 102 may provide the dielectric material 102 for multiple microstrips. In some embodiments, as discussed further below with reference to FIGS. 8-10, the IC support structure 100 may be included in a package substrate or a circuit board. In some such embodiments, the dielectric material 102 may be an organic dielectric material, the ground plane 132 may be a conductive plane (e.g., a copper plane) in one layer of the package substrate/circuit board, and the conductive lines 104 may be conductive lines (e.g., copper lines) in another, adjacent layer of the package substrate/circuit board. More generally, the dielectric material 102 may include any suitable dielectric material 102, and the conductive lines 104 and the ground plane 132 may include any suitable conductive materials. As discussed below with reference to FIGS. 8 and 9, in some embodiments, an IC support structure 100 may be located at a top or bottom face of printed circuit board or package substrate.

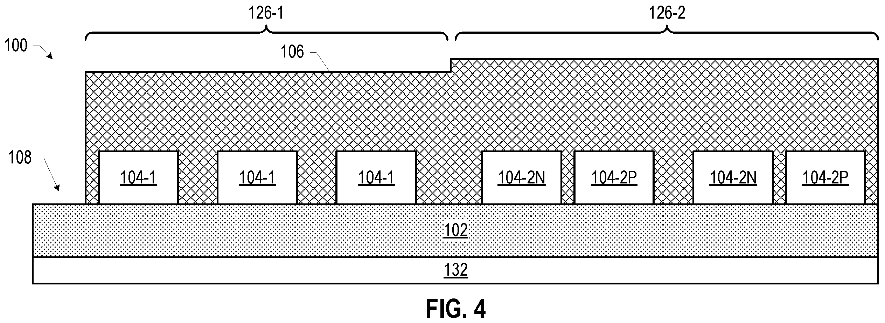

A surface dielectric 106 may be disposed over the conductive lines 104. As shown in FIG. 1, the surface dielectric 106 may be conformal over the conductive lines 104 (e.g., following the contours of the conductive lines 104), while in other embodiments, the surface dielectric 106 may be non-conformal; FIG. 4 illustrates an embodiment in which the surface dielectric 106 is substantially non-conformal. The surface dielectric 106 may include any suitable dielectric material. For example, in some embodiments, the surface dielectric 106 may be a solder mask. The surface dielectric 106 may be deposited over the entireties of the conductive lines 104 or only portions of the conductive lines 104. The surface dielectric 106 in an IC support structure 100 may have a non-uniform thickness over the microstrips, with the surface dielectric 106 having different thicknesses 112-1 in different surface dielectric regions 126. For example, FIG. 1 illustrates an embodiment in which an IC support structure 100 includes two different surface dielectric regions 126, the surface dielectric region 126-1 and the surface dielectric region 126-2, with different thicknesses 112 of the surface dielectric 106 therein (the thicknesses 112-1 and 112-2, respectively). Although two different surface dielectric regions 126 are depicted in FIG. 1, this is simply for ease of illustration, and an IC support structure 100 may include any desired number of surface dielectric regions 126 with surface dielectric 106 having different thicknesses 112 between the surface dielectric regions 126. Surface dielectric regions 126 having different thicknesses cannot be readily manufactured using conventional solder mask processes (in which a solder mask is deposited at a uniform thickness over an entire surface, and then etched away entirely in some areas), and thus, in some embodiments, surface dielectric regions 126 having different thicknesses may be formed by additive manufacturing (e.g., using a three-dimensional (3D) printer, as discussed below with reference to FIG. 3). In some embodiments, use of the techniques and structures disclosed herein may reduce far-end crosstalk between microstrips by 90% or more relative to the use of a single uniform thickness of a solder mask material.

Use of surface dielectric regions 126 having different thicknesses 112 of the surface dielectric 106 in an IC support structure 100 may serve to reduce the far-end crosstalk between microstrips during operation. Relative to stripline routing (in which a conductive trace is sandwiched between two conductive planes), microstrip routing requires fewer layers in an IC support. However, conventional microstrip routing may suffer from greater far-end crosstalk than stripline routing, which may significantly degrade the signal integrity. Further, this degradation increases as the speed of communication increases. Consequently, conventional microstrip routing may be inadequate to achieve adequate communication speeds and integrity in next-generation devices. The IC support structures 100 disclosed herein may exhibit reduced far-end crosstalk relative to conventional approaches by controlling the thickness 112 of the proximate surface dielectric 106, and thus controlling the mutual capacitance between microstrips and affecting the far-end crosstalk between the microstrips. For a particular surface dielectric region 126, a thickness 112 of the surface dielectric 106 may be identified that achieves a desired (e.g., minimal) far-end crosstalk between the microstrips under that surface dielectric region 126; if the thickness 112 is too high or too low, the result may be an increase in far-end crosstalk relative to a more "optimal" thickness 112. The amount of mutual capacitance introduced by the surface dielectric regions 126 of varying thickness 112 may be a function of the geometry and dimensions of the IC support structure 100 (as discussed further below), and may be readily tuned during the design phase, providing good design flexibility (e.g., as discussed further below with reference to FIG. 3). Further, although increasing the thickness of the surface dielectric 106 over a microstrip may increase the undesirable insertion loss of the channel (to which some protocols, such as Ultra Path Interconnect (UPI) may be particularly sensitive), the reduction in far-end crosstalk achieved by the techniques and structures disclosed herein may result in an overall improvement in signal-to-noise ratio (SNR) or insertion-loss-to-crosstalk ratio (ICR).

In some embodiments, a surface dielectric region 126 over single-ended microstrips (e.g., the surface dielectric region 126-1 of FIG. 1) may have a thickness 112 (e.g., the thickness 112-1) that is greater than or less than a thickness 112 (e.g., the thickness 112-2) of a surface dielectric region 126 over differential microstrips (e.g., the surface dielectric region 126-2 of FIG. 1). For example, the thickness 112 of a surface dielectric region 126 over single-ended microstrips may be between 2.5 mils and 3.5 mils (e.g., approximately 3 mils) while the thickness 112 of a surface dielectric region 126 over differential microstrips may be between 4 mils and 5 mils (e.g., approximately 4.5 mils). In some particular embodiments, the thickness 112 of a surface dielectric region 126-1 over single-ended microstrips may be greater than the thickness 112 of a surface dielectric region 126-2 over differential microstrips. Further, different surface dielectric regions 126 over single-ended microstrips may have different thicknesses 112, individual ones of which may be greater than, equal to, or less than thicknesses 112 of different surface dielectric regions 126 over differential microstrips. For example, the thickness 112 of a surface dielectric region 126 over one portion of a set of microstrips may be different than the thickness 112 of another surface dielectric region 126 over another portion of the set of microstrips (due to, e.g., different inter-conductor spacing 130 proximate to the different surface dielectric regions 126).

Although a single reference numeral "106" is used to refer to the surface dielectric 106 in FIG. 1, different ones of the surface dielectric regions 126 in an IC support structure 100 may have the same or different material compositions, as desired. For example, in some embodiments, all of the surface dielectric regions 126 in an IC support structure 100 may have a same material composition, while in other embodiments, surface dielectrics 106 having two or more different material compositions may be used in two or more different surface dielectric regions 126 in an IC support structure 100. In some embodiments, a surface dielectric 106 included in a surface dielectric region 126 may have a loss tangent of approximately 0.02 (corresponding, for example, to the loss tangent of some conventional solder mask materials). In some embodiments, a surface dielectric 106 included in a surface dielectric region 126 may have a loss tangent of approximately 0.01 (corresponding, for example, to the loss tangent of some low-loss solder mask materials). In some embodiments, the loss tangent of the surface dielectric 106 of one surface dielectric region 126 may be greater or less than the loss tangent of the surface dielectric 106 of another surface dielectric region (e.g., less than half). In some embodiments, a surface dielectric 106 included in a surface dielectric region 126 may have a dielectric constant between 3.7 and 10 (e.g., between 3.7 and 4, or between 6 and 10). Surface dielectrics 106 with greater dielectric constants may be used to achieve a smaller thickness 112 (and thus potentially reduce costs and improve reliability) relative to surface dielectrics 106 with lesser dielectric constants.

Surface dielectric 106 may not be distributed over an entire surface of an IC support structure 100. For example, FIG. 1 illustrates a region 108 at a surface of the IC support structure 100 that does not include any surface dielectric 106; instead, the dielectric material 102 (or another dielectric material) may be exposed in the region 108.

The dimensions of the elements of an IC support structure 100 may take any suitable value. In some embodiments, the thickness 128 of the dielectric material 102 may be between 50 microns and 150 microns. In some embodiments, the thickness 112 of the surface dielectric 106 in a surface dielectric region 126 (e.g., as measured above a conductive line 104) may be between 1 mil and 5 mils. In some embodiments, the thickness 116 of a conductive line 104 may be between 15 microns and 50 microns. In some embodiments, a width 118 of the conductive lines 104 may be between 75 microns and 200 microns. In some embodiments, the spacing 130 between two adjacent single-ended conductive lines 104-1 may be between 75 microns and 500 microns. The intra-pair spacing 134 of the differential conductive lines 104-2, and the inter-pair spacing 136 of the differential conductive lines 104-2, may take any desired values. Note that any of these dimensions may be non-uniform across different ones of the corresponding elements. For example, different ones of the conductive lines 104 may have different widths 118 and/or thicknesses 116, and the pitches 130 may vary.

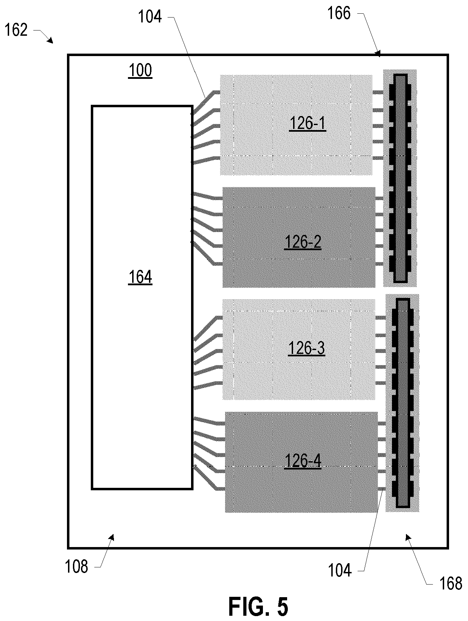

The IC support structures 100 disclosed herein may be included in any desired electronic component. For example, FIG. 2 is a top view of an IC assembly 162 including an IC support structure 100, in accordance with various embodiments. The IC assembly 162 may include a first IC device 164 communicatively coupled to a second IC device 166 by conductive lines 104 (which may be part of single-ended and/or differential microstrips, as desired). The IC assembly 162 may also include third IC device 168; the first IC device 164 may be communicatively coupled to the third IC device 168 by conductive lines 104 (which may be part of single-ended and/or differential microstrips, as desired). In some embodiments, the first IC device 164 may include a processing device (e.g., a central processing unit (CPU), a graphics processing unit (GPU), or a field programmable gate array (FPGA)), and the second IC device 166 and the third IC device 168 may include memory devices (e.g., dual inline memory modules). Different surface dielectric regions 126-1 and 126-3 may be disposed over some of the conductive lines 104 between the first IC device 164 and the second IC device 166, and different surface dielectric regions 126-2 and 126-4 may be disposed over some of the conductive lines 104 between the first IC device 164 and the third IC device 168. Any of these surface dielectric regions 126 may take any of the forms disclosed herein; for example, two or more of the surface dielectric regions 126 may have different thicknesses 112 of the surface dielectric 106 (not shown). Further, as discussed above, in some embodiments, two or more of the surface dielectric regions 126 may have different material compositions (e.g., different loss tangents, as desired). FIG. 5 is another example of an IC assembly 162 including an IC support structure 100; the elements of the IC assembly 162 of FIG. 5 may take the form of any of the embodiments of these elements disclosed herein.

In some embodiments, different surface dielectric regions 126 may be disposed over different high-speed channels in an IC support, reducing far-end crosstalk and therefore improving electrical performance. Such improvements may be particularly advantageous for high-speed channels that are more sensitive to channel crosstalk, such as Peripheral Component Interconnect Express (PCIe) Generation 5 and Generation 6 (e.g., running at 32 gigabits per second non-return-to-zero (NRZ) differential and 64 gigabytes per second pulse-amplitude-modulation 4-level (PAM4) differential, respectively) and Double Data Rate 5 (DDR5) and Graphics Double Data Rate 6 (GPDDR6) (e.g., running at 6.4 gigabytes per second single-ended and 16 gigabits per second single-ended, respectively). Other high-speed channels that may benefit from the techniques and structures disclosed herein may include 112G Ethernet and 224G Ethernet. The conductive lines 104 of FIG. 1, FIG. 2, FIG. 4, and/or FIG. 5 may be part of any of the high-speed channels discussed herein, or any other high-speed channels.

As noted above, selecting the thickness 112 of the surface dielectric 106 in a surface dielectric region 126 of an IC support structure 100 may be part of the design and manufacturing process. FIG. 3 is a flow diagram of an example method 200 of manufacturing such an IC support structure 100, in accordance with various embodiments. Operations are illustrated once each and in a particular order in FIG. 3, but the operations may be reordered and/or repeated as desired (e.g., with different operations performed in parallel when forming multiple surface dielectric regions 126).

At 202, models of an IC support may be created, with different models (e.g., electrical models) having different surface dielectric thicknesses in different surface dielectric regions. Any conventional circuit board simulation software may be used.

At 204, for each surface dielectric region, a thickness may be identified that achieves a desired far-end crosstalk. For example, the far-end crosstalk may be simulated for a surface dielectric region having a particular thickness, and that far-end crosstalk may be compared to the simulated far-end crosstalk associated with a different thickness, until a minimum or other desired far-end crosstalk (and associated thickness) is identified.

At 206, a 3D printer may be programmed to deposit a surface dielectric at the identified thicknesses in the different surface dielectric regions. For example, a 3D printer may be programmed with the areas corresponding to the different surface dielectric regions, and a surface dielectric thickness associated with each region may also be programmed. In some embodiments, the operations of 206 may include specifying a thickness-per-round of deposition and a number of rounds to be performed to achieve a desired thickness in a particular surface dielectric region.

At 208, the surface dielectric may be printed by the 3D printer onto an underlying structure at the identified thicknesses in the different surface dielectric regions. In some embodiments, surface dielectrics 106 having different material compositions may be loaded into the 3D printer for printing in different surface dielectric regions 126. The resulting assembly may include an IC support structure 100 in accordance with any of the embodiments disclosed herein.

As noted above, the IC support structures 100 disclosed herein may include or be included in any suitable electronic component. FIGS. 6-10 illustrate various additional examples of apparatuses that may include any of the IC support structures 100 disclosed herein, or may be included in an IC package or assembly that also includes any of the IC support structures 100 disclosed herein.

FIG. 6 is a top view of a wafer 1500 and dies 1502 that may be included in an IC package or assembly including one or more of IC support structures 100 (e.g., as discussed below with reference to FIGS. 8 and 9) in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 7, discussed below) and/or supporting circuitry to route electrical signals to the transistors, as well as any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 10) or other logic that is configured to store information in the memory devices or execute instructions stored in the memory array.

FIG. 7 is a side, cross-sectional view of an IC device 1600 that may be included in an IC package or assembly including one or more IC support structures 100 (e.g., as discussed below with reference to FIGS. 8 and 9), in accordance with any of the embodiments disclosed herein. One or more of the IC devices 1600 may be included in one or more dies 1502 (FIG. 6). The IC device 1600 may be formed on a substrate 1602 (e.g., the wafer 1500 of FIG. 6) and may be included in a die (e.g., the die 1502 of FIG. 6). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 6) or a wafer (e.g., the wafer 1500 of FIG. 6).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 7 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 7 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 7). Although a particular number of interconnect layers 1606-1610 is depicted in FIG. 7, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 7. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 7. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 7, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

FIG. 8 is a side, cross-sectional view of an example IC package 1650 that may include one or more IC support structures 100 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 7. The package substrate 1652 may be an IC support, and may include one or more IC support structures 100. FIG. 8 illustrates three IC support structures 100 in the package substrate 1652, but this number and location of IC support structures 100 in the package substrate 1652 is simply illustrative, and any number and arrangement of IC support structures 100 may be included in a package substrate 1652. In some embodiments, one or more IC support structures 100 may be located at a surface of the package substrate 1652 (e.g., a top surface of the package substrate 1652 and/or a bottom surface of the package substrate 1652) and/or may be embedded in the package substrate 1652 and spaced away from a surface. In some embodiments, no IC support structures 100 may be included in a package substrate 1652.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to other devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 8 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.). The interposer 1657 may be an IC support, and may include one or more IC support structures 100. FIG. 8 illustrates one IC support structure 100 in the interposer 1657, but this number and location of IC support structures 100 in the interposer 1657 is simply illustrative, and any number and arrangement of IC support structures 100 may be included in an interposer 1657. In some embodiments, one or more IC support structures 100 may be located at a surface of the interposer 1657 (e.g., a top surface of the interposer 1657 and/or a bottom surface of the interposer 1657) and/or may be embedded in the interposer 1657 and spaced away from a surface. In some embodiments, no IC support structures 100 may be included in an interposer 1657.

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 8 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 8 are solder balls (e.g., for a ball grid array arrangement), but any suitable second-level interconnects 16770 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 9.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high bandwidth memory).

Although the IC package 1650 illustrated in FIG. 8 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 8, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 9 is a side, cross-sectional view of an IC device assembly 1700 that may include one or more IC packages or other components (e.g., a circuit board or interposer) including one or more IC support structures 100, in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 8 (e.g., may include one or more IC support structures 100 in a package substrate 1652 or in an interposer 1657).

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate. The circuit board 1702 may be an IC support, and may include one or more IC support structures 100. FIG. 9 illustrates four IC support structures 100 in the circuit board 1702, but this number and location of IC support structures 100 in the circuit board 1702 is simply illustrative, and any number and arrangement of IC support structures 100 may be included in a circuit board 1702. In some embodiments, one or more IC support structures 100 may be located at a surface of the circuit board 1702 (e.g., a first face 1740 of the circuit board 1702 and/or a second face 1742 of the circuit board 1702).

The IC device assembly 1700 illustrated in FIG. 9 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 9), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 9, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 6), an IC device (e.g., the IC device 1600 of FIG. 7), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 9, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art. In some embodiments, the package interposer 1704 may include one or more IC support structures 100 (not shown).

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 9 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 10 is a block diagram of an example electrical device 1800 that may include one or more IC support structures 100 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 10 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 10, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), CPUs, GPUs, cryptoprocessors (specialized processors that execute cryptographic algorithms within hardware), server processors, or any other suitable processing devices. The electrical device 1800 may include one or more storage devices 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM). Communications to and from high-speed storage devices 1804, such as SAS/SATA devices and/or NVMe-based solid state drives (SSDs), may particularly benefit from the IC support structures and techniques disclosed herein.

In some embodiments, the electrical device 1800 may include one or more networking devices 1812 (e.g., one or more communication chips). For example, a networking device 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

A networking device 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. A networking device 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. A networking device 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). A networking device 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. A networking device 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, a networking device 1812 may manage wired communications, such as electrical, optical, or any other suitable communication protocols (e.g., the Ethernet). As noted above, a networking device 1812 may include multiple communication chips. For instance, a first networking device 1812 may be dedicated to shorter-range wireless communications such as Wi-Fi or Bluetooth, and a second networking device 1812 may be dedicated to longer-range wireless communications such as global positioning system (GPS), EDGE, GPRS, CDMA, WiMAX, LTE, EV-DO, or others. In some embodiments, a first networking device 1812 may be dedicated to wireless communications, and a second networking device 1812 may be dedicated to wired communications. Communications to and from high-speed networking devices 1812 may particularly benefit from the IC support structures and techniques disclosed herein.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 is an integrated circuit (IC) support, including: a first microstrip; a first surface dielectric region over the first microstrip, wherein the first surface dielectric region has a first thickness, and the first thickness is nonzero; a second microstrip; and a second surface dielectric region over the second microstrip, wherein the second surface dielectric region has a second thickness, the second thickness is nonzero, and the first thickness is different than the second thickness.

Example 2 includes the subject matter of Example 1, and further specifies that the first microstrip is a single-ended microstrip, and the second microstrip is a differential microstrip.

Example 3 includes the subject matter of Example 2, and further specifies that the first thickness is less than the second thickness.

Example 4 includes the subject matter of any of Examples 1-3, and further specifies that the first surface dielectric region and the second surface dielectric region are at a surface of the IC support, and the surface of the IC support includes a region with no surface dielectric.

Example 5 includes the subject matter of any of Examples 1-4, and further specifies that the first surface dielectric region has a same material composition as the second surface dielectric region.

Example 6 includes the subject matter of Example 5, and further specifies that the first surface dielectric region has a same loss tangent as the second surface dielectric region.

Example 7 includes the subject matter of Example 6, and further specifies that the first surface dielectric region and the second surface dielectric region have loss tangents that are less than or equal to 0.02.

Example 8 includes the subject matter of Example 6, and further specifies that the first surface dielectric region and the second surface dielectric region have loss tangents that are less than or equal to 0.01.

Example 9 includes the subject matter of any of Examples 1-4, and further specifies that the first surface dielectric region has a different material composition than the second surface dielectric region.

Example 10 includes the subject matter of Example 9, and further specifies that the first surface dielectric region has a different loss tangent than the second surface dielectric region.

Example 11 includes the subject matter of Example 10, and further specifies that the first surface dielectric region has a loss tangent that is less than half of a loss tangent of the second surface dielectric region.

Example 12 includes the subject matter of Example 10, and further specifies that the second surface dielectric region has a loss tangent that is less than half of a loss tangent of the first surface dielectric region.

Example 13 includes the subject matter of any of Examples 1-12, and further includes: a third microstrip; and a third surface dielectric region over the third microstrip, wherein the third surface dielectric region has a third thickness, the third thickness is nonzero, the third thickness is different than the first thickness, and the third thickness is different than the second thickness.

Example 14 includes the subject matter of any of Examples 1-13, and further specifies that the first microstrip includes a first conductive line, a ground plane, and a dielectric material between the first conductive line and the ground plane.

Example 15 includes the subject matter of Example 14, and further specifies that the dielectric material has a different material composition than the first surface dielectric region.

Example 16 includes the subject matter of any of Examples 14-15, and further specifies that the dielectric material is an organic dielectric material.

Example 17 includes the subject matter of any of Examples 1-16, and further specifies that the IC support includes a package substrate or a circuit board.

Example 18 includes the subject matter of any of Examples 1-16, and further specifies that the first surface dielectric region includes a solder mask.

Example 19 is an electronic device, including: an integrated circuit (IC) device; and an IC support coupled to the IC device, wherein the IC support includes a first microstrip region and a second microstrip region, the IC support further includes a surface dielectric over the first microstrip region and the second microstrip region, and the surface dielectric has a non-uniform thickness over the first microstrip region and the second microstrip region.

Example 20 includes the subject matter of Example 19, and further specifies that the first microstrip region includes at least one single-ended microstrip, and the second microstrip region includes at least one differential microstrip.

Example 21 includes the subject matter of Example 20, and further specifies that the surface dielectric is less thick over the first microstrip region than over the second microstrip region.

Example 22 includes the subject matter of any of Examples 19-21, and further specifies that the surface dielectric is at a surface of the IC support, and the surface of the IC support includes a region with no surface dielectric.

Example 23 includes the subject matter of any of Examples 19-22, and further specifies that the surface dielectric has a non-uniform material composition over the first microstrip region and the second microstrip region.

Example 24 includes the subject matter of Example 23, and further specifies that the surface dielectric over the first microstrip region has a same loss tangent as the surface dielectric over the second microstrip region.

Example 25 includes the subject matter of any of Examples 24, and further specifies that the surface dielectric over the first microstrip region and the surface dielectric over the second microstrip region have loss tangents that are less than or equal to 0.02.

Example 26 includes the subject matter of Example 24, and further specifies that the surface dielectric over the first microstrip region and the surface dielectric over the second microstrip region have loss tangents that are less than or equal to 0.01.

Example 27 includes the subject matter of any of Examples 19-22, and further specifies that the surface dielectric over the first microstrip region has a different material composition than the surface dielectric over the second microstrip region.

Example 28 includes the subject matter of Example 27, and further specifies that the surface dielectric over the first microstrip region has a different loss tangent than the surface dielectric over the second microstrip region.

Example 29 includes the subject matter of Example 28, and further specifies that the surface dielectric over the first microstrip region has a loss tangent that is less than a loss tangent of the surface dielectric over the second microstrip region.

Example 30 includes the subject matter of Example 28, and further specifies that the surface dielectric over the second microstrip region has a loss tangent that is less than half of a loss tangent of the surface dielectric over the first microstrip region.

Example 31 includes the subject matter of any of Examples 19-30, and further specifies that an individual microstrip of the first microstrip region includes a conductive line, a ground plane, and a dielectric material between the conductive line and the ground plane.

Example 32 includes the subject matter of Example 31, and further specifies that the dielectric material has a different material composition than the surface dielectric over the first microstrip region.

Example 33 includes the subject matter of any of Examples 31-32, and further specifies that the dielectric material is an organic dielectric material.

Example 34 includes the subject matter of any of Examples 19-33, and further specifies that the IC support includes a package substrate.

Example 35 includes the subject matter of any of Examples 19-33, and further specifies that the IC support includes a circuit board.

Example 36 includes the subject matter of any of Examples 19-35, and further specifies that the IC device is a first IC device, and the first microstrip region or the second microstrip region communicatively couples the first IC device to a second IC device.

Example 37 includes the subject matter of Example 36, and further specifies that the first IC device is a processing device.

Example 38 includes the subject matter of Example 37, and further specifies that the first IC device is a central processing unit.

Example 39 includes the subject matter of any of Examples 36-38, and further specifies that the second IC device is a memory device.

Example 40 includes the subject matter of Example 39, and further specifies that the second IC device is a dual inline memory module.

Example 41 includes the subject matter of any of Examples 19-40, and further specifies that the electronic device is a handheld computing device, a laptop computing device, a wearable computing device, or a server computing device.

Example 42 includes the subject matter of any of Examples 19-41, and further specifies that the IC support includes a motherboard.

Example 43 includes the subject matter of any of Examples 19-42, and further includes: a display communicatively coupled to the IC support.

Example 44 includes the subject matter of Example 43, and further specifies that the display includes a touchscreen display.

Example 45 includes the subject matter of any of Examples 19-44, and further specifies that the surface dielectric includes a solder mask.

Example 46 is a method of manufacturing an integrated circuit (IC) support structure, including: determining a first surface dielectric thickness that achieves a desired far-end crosstalk in a first microstrip region; determining a second surface dielectric thickness that achieves a desired far-end crosstalk in a second microstrip region, wherein the first surface dielectric thickness is different than the second surface dielectric thickness; and programming a three-dimensional (3D) printer to deposit a surface dielectric having the first surface dielectric thickness over the first microstrip region and having the second surface dielectric thickness over the second microstrip region.

Example 47 includes the subject matter of Example 46, and further includes: causing the 3D printer to deposit a surface dielectric having the first surface dielectric thickness over the first microstrip region and having the second surface dielectric thickness over the second microstrip region.

Example 48 includes the subject matter of any of Examples 46-47, and further includes: determining a third surface dielectric thickness that achieves a desired far-end crosstalk in a second microstrip region, wherein the third surface dielectric thickness is different than the second surface dielectric thickness and the third surface dielectric thickness is different than the first surface dielectric thickness; and programming the 3D printer to deposit a surface dielectric having the third surface dielectric thickness over the third microstrip region.

Example 49 includes the subject matter of any of Examples 46-48, and further specifies that programming the 3D printer to deposit a surface dielectric having the first surface dielectric thickness over the first microstrip region and having the second surface dielectric thickness over the second microstrip region includes programming the 3D printer to deposit a surface dielectric having a first material composition over the first microstrip region and to deposit a surface dielectric having a second material composition over the second microstrip region, and the first material composition is different than the second material composition.

Example 50 includes the subject matter of any of Examples 46-49, and further specifies that the surface dielectric includes a solder mask.

## Claims

1. An integrated circuit (IC) support, comprising:
a first microstrip;
a first surface dielectric region over the first microstrip, wherein the first surface dielectric region has a first thickness, and the first thickness is nonzero;
a second microstrip; and
a second surface dielectric region over the second microstrip, wherein the second surface dielectric region has a second thickness, the second thickness is nonzero, and the first thickness is different than the second thickness.

2. The IC support of claim 1, wherein the first thickness is less than the second thickness.

3. The IC support of claims 1 or 2, wherein the first surface dielectric region and the second surface dielectric region are at a surface of the IC support, and the surface of the IC support includes a region with no surface dielectric.

4. The IC support of any one of claims 1-3, wherein the first surface dielectric region has a same material composition as the second surface dielectric region.

5. The IC support of any one of claims 1-3, wherein the first surface dielectric region has a different material composition than the second surface dielectric region.

6. The IC support of any one of claims 1-5, wherein the first microstrip includes a first conductive line, a ground plane, and a dielectric material between the first conductive line and the ground plane.

7. The IC support of claim 6, wherein the dielectric material has a different material composition than the first surface dielectric region.

8. The IC support of claim 6, wherein the dielectric material is an organic dielectric material.

9. An electronic device, comprising:
an integrated circuit (IC) device; and
an IC support coupled to the IC device, wherein the IC support includes a first microstrip region and a second microstrip region, the IC support further includes a surface dielectric over the first microstrip region and the second microstrip region, and the surface dielectric has a non-uniform thickness over the first microstrip region and the second microstrip region.

10. The electronic device of claim 9, wherein the IC device is a first IC device, and the first microstrip region or the second microstrip region communicatively couples the first IC device to a second IC device.

11. The electronic device of claim 10, wherein the first IC device is a processing device.

12. The electronic device of claims 10 or 11, wherein the second IC device is a memory device.

13. The electronic device of any one of claims 9-12, wherein the electronic device is a handheld computing device, a laptop computing device, a wearable computing device, or a server computing device.

14. A method of manufacturing an integrated circuit (IC) support structure, comprising:
determining a first surface dielectric thickness that achieves a desired far-end crosstalk in a first microstrip region;
determining a second surface dielectric thickness that achieves a desired far-end crosstalk in a second microstrip region, wherein the first surface dielectric thickness is different than the second surface dielectric thickness; and
programming a three-dimensional (3D) printer to deposit a surface dielectric having the first surface dielectric thickness over the first microstrip region and having the second surface dielectric thickness over the second microstrip region.

15. The method of manufacturing the IC support structure of claim 14, further comprising:
causing the 3D printer to deposit a surface dielectric having the first surface dielectric thickness over the first microstrip region and having the second surface dielectric thickness over the second microstrip region.
